# EUROPÄISCHE PATENTSCHRIFT

(11) **EP 2 862 185 B1**
(45) Veröffentlichungstag und Bekanntmachung des Hinweises auf die Patenterteilung: **05.10.2016**
(21) Anmeldenummer: 13725596.4
(22) Anmeldetag: 16.05.2013
(51) Int. Cl.: H01G 4/232, H01G 4/30, H01L 41/047, H01L 41/083, H01L 41/297

(54) **VERFAHREN ZUR HERSTELLUNG EINES ELEKTRISCHEN BAUELEMENTS**
METHOD FOR PRODUCING AN ELECTRIC COMPONENT
PROCÉDÉ DE FABRICATION D'UN ÉLÉMENT ÉLECTRIQUE

(30) Priorität: 18.06.2012 DE 102012105287
(43) Veröffentlichungstag der Anmeldung: 22.04.2015
(73) Patentinhaber: EPCOS AG, 81669 München (DE)
(72) Erfinder: RINNER, Franz, A-8530 Deutschlandsberg (AT); SOMITSCH, Dieter, 8522 Groß St. Florian (AT)
(74) Vertreter: Epping - Hermann - Fischer
(86) Internationale Anmeldenummer: PCT/EP2013/060182
(87) Internationale Veröffentlichungsnummer: WO 2013/189671

(56) Entgegenhaltungen:
- DE-A1-102006 001 656
- DE-A1-102007 004 813
- DE-A1-102008 042 232
- DE-B4- 4 410 504
- JP-A- 2004 119 856
- US-A1- 2010 282 874

## Beschreibung

Es wird ein Verfahren zur Herstellung eines elektrischen Bauelements und ein elektrisches Bauelement angegeben. Das Bauelement ist vorzugsweise ein Vielschichtbauelement. Beispielsweise ist das Bauelement als Piezoaktor ausgebildet, der zum Betätigen eines Einspritzventils in einem Kraftfahrzeug eingesetzt werden kann. Das Bauelement kann beispielsweise auch als Varistor, Kondensator, Heißleiter oder Kaltleiter ausgebildet sein.

In den Druckschriften DE 10 2006 001 656 A1, DE 44 10 504 B4 und DE 10 2007 004 813 A1 sind Ätzverfahren zur Ausbildung von Isolationszonen in Vielschichtbauelementen beschrieben.

Die Isolationszonen werden anschließend mit einem Isolationsmaterial befüllt.

DE 10 2008 042 232 A1, JP 2004 119 856 A und US 2010 / 282 874 A1 offenbaren Verfahren, bei dem dies durch Kapillarkräfte geschieht.

Es ist eine zu lösende Aufgabe, ein verbessertes Verfahren zur Herstellung eines elektrischen Bauelements und ein elektrisches Bauelement mit verbesserten Eigenschaften anzugeben.

Es wird ein Verfahren zur Herstellung eines elektrischen Bauelements angegeben, bei dem ein Körper aufweisend wenigstens eine Kavität bereitgestellt wird. Die Kavität wird durch Kapillarkräfte zumindest teilweise mit einem Isolationsmaterial befüllt. Dazu wird der Körper mit nur einer Seite in ein flüssiges Isolationsmaterial eingebracht. Vorzugsweise weist der Körper eine Vielzahl von Kavitäten auf, die mit dem Isolationsmaterial befüllt werden.

Der Körper ist beispielsweise als Grundkörper für das elektrische Bauelement ausgebildet. Alternativ kann der Körper nach dem Befüllen mit dem Isolationsmaterial in mehrere Grundkörper für elektrische Bauelemente zertrennt werden. Das Bauelement ist vorzugsweise ein piezoelektrisches Bauelement, insbesondere kann das Bauelement als Piezoaktor ausgebildet sein.

Vorzugsweise weist der Körper Elektrodenschichten auf. Vorzugsweise sind die Elektrodenschichten abwechselnd mit dielektrischen Schichten zu einem Stapel angeordnet. Die dielektrischen Schichten sind beispielsweise keramische Schichten, insbesondere piezokeramische Schichten. Der Körper ist vorzugsweise ein monolithischer Sinterkörper.

Vorzugsweise wird im Betrieb des Bauelements zwischen benachbarte Elektrodenschichten eine Spannung angelegt. Die Elektrodenschichten reichen vorzugsweise in Stapelrichtung abwechselnd bis zu einer ersten Seitenfläche des Körpers und sind von einer zweiten Seitenfläche, vorzugsweise einer gegenüberliegenden Seitenfläche, beabstandet. Insbesondere reichen erste Elektrodenschichten bis zu der ersten Seitenfläche und sind von der zweiten Seitenfläche beabstandet. Zweite Elektrodenschichten reichen bis zu der zweiten Seitenfläche und sind von der ersten Seitenfläche beabstandet.

In einer Ausführungsform grenzt die Kavität an eine Elektrodenschicht an. Beispielsweise wird durch die Kavität der Abstand von einer Elektrodenschicht zu einer Seitenfläche erzeugt. In diesem Fall dient die Kavität als Isolationszone, um eine elektrische Isolierung der Elektrodenschicht von der Seitenfläche herzustellen. Vorzugsweise weist der Körper eine Vielzahl von Kavitäten auf, die die ersten und zweiten Elektrodenschichten abwechselnd von Seitenflächen der Körpers isolieren.

Auf diese Weise können die ersten Elektrodenschichten durch eine erste Außenkontaktierung, die auf einer ersten Seitenfläche des Körpers angeordnet ist, gemeinsam elektrisch kontaktiert werden, während die zweiten Elektrodenschichten von dieser Außenkontaktierung isoliert sind. Ebenso können die zweiten Elektrodenschichten von einer zweiten Außenkontaktierung gemeinsam elektrisch werden, die auf einer zweiten Seitenfläche des Stapels angeordnet ist, während die ersten Elektrodenschichten von dieser Außenkontaktierung isoliert sind.

Alternativ oder zusätzlich kann durch die Kavität eine mechanische Entlastung des Körpers erzeugt werden. Mechanische Spannungen können im Körper besonders bei vorhandenen inaktiven Zonen im Bauelement entstehen. In inaktiven Zonen tritt keine Überlappung benachbarter Elektrodenschichten in Stapelrichtung gesehen auf. Beispielsweise entstehen inaktive Zonen, wenn benachbarte Elektrodenschichten im Bauelement abwechselnd bis zu einer Seitenfläche geführt und von der gegenüberliegenden Seitenfläche beabstandet sind.

Alternativ oder zusätzlich können durch die Kavitäten Sollbruchbereiche gebildet werden. Ein Sollbruchbereich ist vorzugsweise eine Schwachstelle im Bauelement, die zur gezielten Erzeugung und Führung von Rissen dient. Auf diese Weise kann eine unkontrollierte Entstehung und Ausbreitung von Rissen im Bauelement verhindert werden, so dass die Gefahr von Kurschlüssen reduziert wird.

In einer Ausführungsform grenzt die Kavität nicht an eine Elektrodenschicht an. In diesem Fall dient die Kavität beispielsweise nur als Sollbruchbereich oder zum Abbau von Spannungen im Körper.

Die Kavität ist beispielsweise durch ein Ätzverfahren in den Körper eingebracht. Hierzu wird der Körper beispielsweise mit vollflächig aufgetragenen Elektrodenschichten hergestellt. Der Körper wird in ein Ätzmedium eingebracht und es wird eine Spannung zwischen den ersten oder zweiten Elektrodenschichten und einer separaten Hilfselektrode angelegt. Auf diese Weise kann ein elektrisch gesteuertes Ätzverfahren durchgeführt werden, bei denen kontrolliert Kavitäten in den Körper eingebracht werden. Mit einem Ätzverfahren können besonders schmale Kavitäten erzeugt werden, die schwierig zu befüllen sind.

Alternativ kann die Kavität auch durch ein anderes Verfahren in den Körper eingebracht werden. Beispielsweise wird die Kavität durch ein mechanisches Verfahren in den Körper eingebracht.

Die Kavität wird zumindest teilweise mit Isolationsmaterial befüllt. Dadurch soll insbesondere ein elektrischer Durchbruch zwischen einer Elektrodenschicht und einer Außenelektrode, die eine andere Polarität als die Elektrodenschicht aufweist, verhindert werden. Beim Anlegen einer Spannung an die Elektrodenschichten über auf die Seitenflächen aufgebrachte Außenelektroden kann es zu einem derartigen, unerwünschten elektrischen Durchbruch kommen. Dieses Problem entsteht dadurch, dass bei einem Elektrodenende eine Feldüberhöhung auftreten kann, die zu einem Lawinendurchbruch zwischen dem Elektrodenende und der durch die Kavität getrennten Außenelektrode führen kann. Insbesondere tritt dies bei einer mit einer positiven Spannung beaufschlagten Außenelektrode und einer als Kathodenspitze wirkenden Elektrodenschicht auf. Ein derartiger Durchbruch kann zur Zerstörung des Bauelements führen. Alternativ oder zusätzlich dazu kann durch das Isolationsmaterial verhindert werden, dass Stoffe, insbesondere elektrisch leitfähige Stoffe in den Körper eindringen und zu einem Kurzschluss führen.

Durch das Einbringen von Isolationsmaterial in die Kavitäten soll die elektrische Durchbruchsspannung erhöht werden und somit ein Durchbruch verhindert werden. Vorzugsweise ist das Isolationsmaterial zwischen einem freiliegenden Ende einer Elektrodenschicht und dem Ort einer Außenelektrode eingebracht. Somit kann das Isolationsmaterial eine Barriere zwischen der Elektrodenschicht und der Außenelektrode bilden und insbesondere einen Lawinendurchbruch verhindern, der zu einer Beschädigung des Bauelements führen kann. Beispielsweise bedeckt das Isolationsmaterial wenigstens ein in der Kavität freiliegendes Ende einer Elektrodenschicht. Vorzugsweise bedeckt das Isolationsmaterial alle in der Kavität freiliegenden Elektrodenschichten. Das Isolationsmaterial kann alternativ oder zusätzlich in einem anderen Bereich zwischen einem freiliegenden Elektrodenende und einer Außenelektrode vorhanden sein. Beispielsweise bedeckt das Isolationsmaterial die zur Kavität gewandte Seite der Außenelektrode.

In einer Ausführungsform ist über die gesamte Länge eines Elektrodenendes Isolationsmaterial zwischen dem Elektrodenende und dem Ort einer Außenelektrode vorhanden. Es kann aber auch nur auf einer Teillänge des Elektrodenendes Isolationsmaterial vorhanden sein. Dies kann insbesondere dann der Fall sein, wenn die Außenelektrode nur über einem Teil der Außenseite aufgebracht wird. Dann ist die Kavität vorzugsweise in dem Bereich mit Isolationsmaterial befüllt, der sich zwischen dem Elektrodenende und dem Ort der Außenelektrode befindet. In einer Ausführungsform wird die Kavität vollständig mit dem Isolationsmaterial befüllt.

In einer Ausführungsform wird zum Befüllen der Kavität mit Isolationsmaterial der Körper zumindest teilweise in ein Isolationsmaterial, insbesondere ein flüssiges Isolationsmaterial, eingebracht.

Der Körper wird mit einer Seitenfläche, an der die Kavität freiliegt, in das Isolationsmaterial eingebracht. Das Isolationsmaterial wird durch Kapillarkräfte in die Kavität hineingezogen und steigt vorzugsweise durch Kapillarkräfte in der Kavität nach oben. Vorzugsweise wird dadurch die Kavität ihrer gesamten Länge nach befüllt.

Die Kavität führt beispielsweise von einer Seitenfläche bis zur gegenüberliegenden Seitenfläche und liegt auf beiden Seitenflächen frei. Der Körper kann dann nur mit einer der Seitenflächen in das Isolationsmaterial eingebracht werden und das Isolationsmaterial wandert dann aufgrund von Kapillarkräften bis zur gegenüberliegenden Seitenfläche. Steigt das Isolationsmaterial von unten nach oben in der Kavität, kann Luft durch die obere Öffnung der Kavität entweichen. Vorzugsweise wird der Körper mit der Seitenfläche in das Isolationsmaterial eingebracht, die nicht zur Anordnung einer Außenkontaktierung vorgesehen ist. Alternativ kann die Kavität auch nur über einen Teil ihrer Länge mit Isolationsmaterial befüllt werden. Beispielsweise steigt in diesem Fall das Isolationsmaterial nicht bis nach ganz oben. Vor Einbringen des Körpers in das Isolationsmaterials können Teile des Körpers abgedeckt, insbesondere abgeklemmt, werden, so dass diese Teile frei vom Isolationsmaterial bleiben.

In einer nicht zur Erfindung gehörenden weiteren Ausführungsform wird das Isolationsmaterial auf den Körper aufgebracht. Insbesondere wird das Isolationsmaterial auf eine Seitenfläche aufgebracht, auf der die Kavitäten freiliegen. Das Isolationsmaterial wird dann durch Kapillarkräfte in die Kavitäten hineingezogen. Beispielsweise wird dabei das Isolationsmaterial wenigstens auf den Bereich einer Seitenfläche aufgebracht, auf dem später eine Außenelektrode angeordnet wird. Vorzugsweise ist die Fläche, auf der das Isolationsmaterial aufgebracht wird, größer als die Fläche, auf der die Außenelektrode angeordnet wird.

Beispielsweise kann das Isolationsmaterial durch Siebdruck auf den Körper aufgebracht werden. Dieses Verfahren eignet sich besonders gut bei Glas als Isolationsmaterial. Das Glas kann über einen Einbrandprozess verflüssigt werden und dringt dann aufgrund von Kapillarkräften in die Kavität ein. Beispielsweise befüllt das Isolationsmaterial nur einen Bereich der Kavität nahe der Seitenfläche und dringt nicht bis zu den Elektrodenenden vor.

Das flüssige Isolationsmaterial ist vorzugsweise derart gewählt, dass es das Material, das an die Kavität angrenzt, gut benetzt.

In einer Ausführungsform weist das Isolationsmaterial einen Lack auf. Beispielsweise weist das Isolationsmaterial ein organisches Material auf. Insbesondere kann es sich um einen Lack auf Alkoholbasis handeln. Durch ein derartiges Lösungsmittel kann eine gute Benutzung eines Keramikmaterials, insbesondere von PZT erreicht werden. Der Lack kann auch zur Außenpassivierung des Körpers verwendet werden. Nach dem Einbringen in die Kavitäten wird der Lack ausgehärtet.

In einer weiteren Ausführungsform weist das Isolationsmaterial Glas auf. Das Glas liegt dabei beim Einbringen in die Kavitäten oberhalb seiner Schmelztemperatur vor. Beispielsweise weist das Glas eine Blei- oder Siliziumbasis auf. Der Schmelzpunkt des Glases liegt vorzugsweise oberhalb der Einbrandtemperatur der Außenkontaktierung. Das Glas weist eine ausreichend niedrige Viskosität auf, so dass es die Kavitäten befüllen kann. Insbesondere bei Glas als Isolationsmaterial ist es möglich, auch nach dem Befüllen der Kavität noch Hochtemperatur-Prozesse durchzuführen. Beispielsweise kann die Außenkontaktierung nach Einbringen des Isolationsmaterials als Metallpaste aufgebracht und eingebrannt werden. Weiterhin weist Glas eine besonders hohe elektrische Durchschlagsfestigkeit auf. Beispielsweise wird das Glas als Paste über den Kavitäten aufgetragen und in einem Einbrandprozess verflüssigt.

Vorzugsweise wird eine Außenkontaktierung auf den Körper aufgebracht. In einer Ausführungsform wird die Außenkontaktierung vor dem Einbringen von Isolationsmaterial, beispielsweise vor dem Einbringen des Körpers in ein flüssiges Isolationsmaterial, auf den Körper aufgebracht.

Vorzugsweise dient die Außenkontaktierung zur Kontaktierung von Elektrodenschichten. Beispielsweise werden eine erste Außenkontaktierung zur Kontaktierung der ersten Elektrodenschichten und eine zweite Außenkontaktierung zur Außenkontaktierung der zweiten Elektrodenschichten aufgebracht. Beispielsweise wird die Außenkontaktierung eingebrannt. Dabei wird die Außenkontaktierung vorzugsweise in Form einer Metallpaste auf eine Seitenfläche, beispielsweise in einem Siebdruckverfahren, aufgetragen und anschließend eingebrannt.

Vorzugsweise bedeckt die Außenkontaktierung zumindest teilweise die Kavität. Insbesondere ist bei einem Aufbringen der Außenkontaktierung vor dem Befüllen der Kavität mit Isolationsmaterial unterhalb der Außenkontaktierung ein Hohlraum vorhanden. Das Isolationsmaterial kann dann durch den Kapillareffekt in die unter der Außenkontaktierung liegende Kavität eingebracht werden.

Dies hat den Vorteil, dass das Isolationsmaterial kontrolliert nur in die Kavität eingebracht werden kann und insbesondere keine Elektrodenschichten, die bis an die Seitenfläche reichen, auf dieser Seitenfläche bedeckt. Somit können weitere Bearbeitungsschritte, wie z. B. ein Polieren einer Seitenfläche, entfallen.

Weiterhin können bei einem Aufbringen der Außenkontaktierung vor dem Befüllen der Kavität mit dem Isolationsmaterial Prozessschritte zum Aufbringen der Außenkontaktierung durchgeführt werden ohne dass die Gefahr einer Beschädigung des Isolationsmaterials besteht. Beispielsweise können Hochtemperaturprozesse, z. B. ein Einbrand einer als Metallpaste aufgebrachten Außenkontaktierung durchgeführt werden. Anschließend kann ein Isolationsmaterial, das nicht für Hochtemperaturprozesse geeignet ist, insbesondere ein organisches Isolationsmaterial in die Kavität eingebracht werden.

In einer alternativen Ausführungsform wird die Außenkontaktierung nach dem Einbringen des Isolationsmaterials auf den Körper aufgebracht. Beispielsweise kann die Außenkontaktierung als Metallpaste auf eine Seitenfläche aufgetragen und eingebrannt werden. Alternativ kann die Außenkontaktierung auch durch Sputtern aufgebracht werden. Alternativ kann die Außenkontaktierung als Leitkleber ausgebildet sein.

Vorzugsweise weist der Körper mehrere Kavitäten auf. Die Kavitäten können an verschiedenen Seitenflächen angeordnet sein. Beispielsweise ist eine erste Kavität an einer ersten Seitenfläche und eine zweite Kavität an einer zweiten Seitenfläche angeordnet. Die auf den verschiedenen Seitenflächen angeordneten Kavitäten werden in einem einstufigen Verfahren mit dem Isolationsmaterial befüllt. Insbesondere werden die Kavitäten gleichzeitig mit dem Isolationsmaterial befüllt. Somit entfällt ein mehrstufiges Einbringen von Isolationsmaterial, z. B. in einem ersten Schritt ein Einbringen von Isolationsmaterial in die an der ersten Seitenfläche angeordneten Kavitäten und in einem nachfolgenden zweiten Schritt ein Einbringen von Isolationsmaterial in die an der zweiten Seitenfläche angeordneten Kavitäten.

Weiterhin wird ein elektrisches Bauelement angegeben, welches nicht zur Erfindung gehört, das einen Körper mit einer Kavität aufweist, wobei die Kavität zumindest teilweise mit einem organischen Isolationsmaterial gefüllt ist. Vorzugsweise bildet der Körper einen Grundkörper des Bauelements. Die Kavität ist zumindest teilweise von einer eingebrannten Außenkontaktierung bedeckt.

Vorzugsweise ist die eingebrannte Außenkontaktierung auf einer Seitenfläche des Körpers angeordnet. Die Außenkontaktierung dient beispielsweise zur Kontaktierung von Elektrodenschichten.

Das Bauelement kann mit dem hier beschriebenen Verfahren hergestellt werden und kann alle funktionellen und strukturellen Merkmale aufweisen, die bezüglich des Verfahrens beschrieben sind.

Beispielsweise kann das organische Isolationsmaterial wie im obigen Verfahren beschrieben durch Kapillarkräfte in die Kavität eingebracht werden. Dabei kann insbesondere zuerst die Außenkontaktierung aufgebracht und eingebrannt werden. Anschließend kann das organische Isolationsmaterial unter die eingebrannte Außenkontaktierung in die Kavitäten eingebracht werden. Danach kann das organische Isolationsmaterial ausgehärtet werden. Das organische Isolationsmaterial ist beispielsweise ein organischer Lack.

Vorzugsweise weist der Körper wenigstens eine Elektrodenschicht auf. Das organische Isolationsmaterial ist beispielsweise zwischen der Elektrodenschicht und der Außenkontaktierung angeordnet. Die Kavität mit dem organischen Isolationsmaterial kann somit wie oben beschrieben zur elektrischen Isolierung von

Elektrodenschichten zu einer Außenkontaktierung dienen.

Alternativ oder zusätzlich kann die Kavität eine Sollbruchstelle bilden.

Weiterhin wird ein elektrisches Bauelement angegeben, das einen Körper mit wenigstens einer Kavität aufweist, die zumindest teilsweise mit einem Isolationsmaterial gefüllt ist. Vorzugsweise bildet der Körper einen Grundkörper des Bauelements. Das Isolationsmaterial ist durch Kapillarkräfte in die Kavität eingebracht.

Das Bauelement kann mit dem hier beschriebenen Verfahren hergestellt werden und kann alle funktionellen und strukturellen Merkmale aufweisen, die bezüglich des Verfahrens beschrieben sind.

Im Folgenden werden die hier beschriebenen Gegenstände anhand von schematischen und nicht maßstabsgetreuen Ausführungsbeispielen näher erläutert.

Es zeigen:
- Figur 1: in einer schematischen perspektivischen Ansicht einen Körpers für ein Vielschichtbauelement,
- Figur 2: in schematischer Darstellung den Schritt des Einbringens von Isolationsmaterial in Kavitäten des Körpers aus Figur 1,
- Figur 3: eine seitliche Aufsicht auf den Körper aus Figur 1 vor dem Einbringen von Isolationsmaterial gemäß einem ersten Verfahrensablauf,
- Figur 4: eine seitliche Aufsicht auf den Körper aus Figur 3 nach dem Einbringen von Isolationsmaterial gemäß dem ersten Verfahrensablauf,
- Figur 5: eine seitliche Aufsicht auf den Körper aus Figur 4 nach dem Aufbringen von Außenelektroden gemäß dem ersten Verfahrensablauf,
- Figur 6: eine seitliche Aufsicht auf den Körper aus Figur 1 vor dem Einbringen von Isolationsmaterial gemäß dem zweiten Verfahrensablauf,
- Figur 7: eine seitliche Aufsicht auf den Körper aus Figur 6 nach dem Aufbringen von Außenkontaktierungen gemäß dem zweiten Verfahrensablauf,
- Figur 8: eine seitliche Aufsicht auf den Körper aus Figur 7 nach dem Einbringen von Isolationsmaterial gemäß dem zweiten Verfahrensablauf.

Vorzugsweise verweisen in den folgenden Figuren gleiche Bezugszeichen auf funktionell oder strukturell entsprechende Teile der verschiedenen Ausführungsformen.

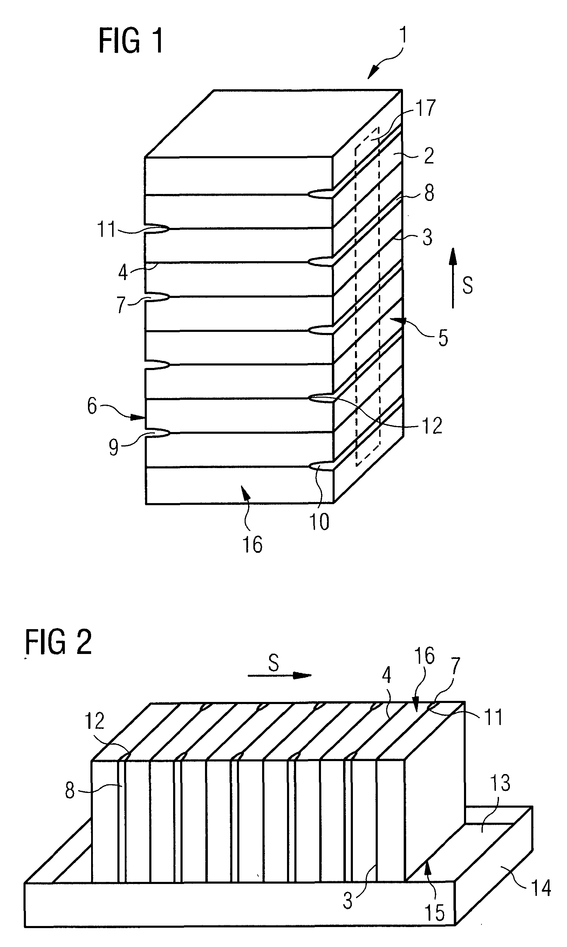

Figur 1 zeigt eine schematische perspektivische Ansicht eines Körpers 1 für ein elektrisches Bauelement.

Der Körper 1 weist einen Stapel aus dielektrischen Schichten 2 und dazwischen angeordneten Elektrodenschichten 3, 4 auf. Die Schichten 2, 3, 4 sind entlang einer Stapelrichtung S übereinander gestapelt. Die Stapelrichtung S entspricht der Längsachse des Körpers 1.

Der hier abgebildete Körper 1 ist ein Grundkörper für ein Bauelement, beispielsweise für einen Piezoaktor. In einer anderen Ausführungsform wird der Körper in einem späteren Verfahrensschritt in mehrere Grundkörper zertrennt.

Die dielektrischen Schichten 2 enthalten beispielsweise ein Keramikmaterial. Vorzugsweise sind die dielektrischen Schichten 2 als piezoelektrische Schichten ausgebildet, insbesondere als piezokeramische Schichten.

Der abgebildete Körper 1 ist vorzugsweise ein gesinterter Körper. Besonders bevorzugt ist der Körper 1 ein monolithischer Sinterkörper, so dass die Elektrodenschichten 3, 4 gemeinsam mit den dielektrischen Schichten 2 gesintert sind.

Die Elektrodenschichten 3, 4 enthalten vorzugsweise ein Metall. Besonders bevorzugt enthalten die Elektrodenschichten 3, 4 Kupfer oder bestehen aus Kupfer. In weiteren Ausführungsformen können die Elektrodenschichten 3, 4 beispielsweise Silber oder Silber-Palladium enthalten.

Die Elektrodenschichten 3, 4 weisen erste Elektrodenschichten 3 und zweite Elektrodenschichten 4 auf, die abwechselnd übereinander angeordnet sind. Die ersten Elektrodenschichten 3 reichen bis zu einer ersten Seitenfläche 5 des Körpers 1 und sind von einer zweiten, gegenüberliegenden Seitenfläche 6 beabstandet. Die zweiten Elektrodenschichten 4 sind von der ersten Seitenfläche 5 des Körpers 1 beabstandet und reichen bis zu der zweiten, gegenüberliegenden Seitenfläche 6.

Im Körper 1 sind angrenzend an die Elektrodenschichten 3, 4 erste und zweite Kavitäten 7, 8 ausgebildet, durch die die Elektrodenschichten 3, 4 abwechselnd von den Seitenflächen 5, 6 zurückgesetzt sind. Die Kavitäten 7, 8 reichen beispielsweise 100 µm in das Innere des Körpers 1 hinein.

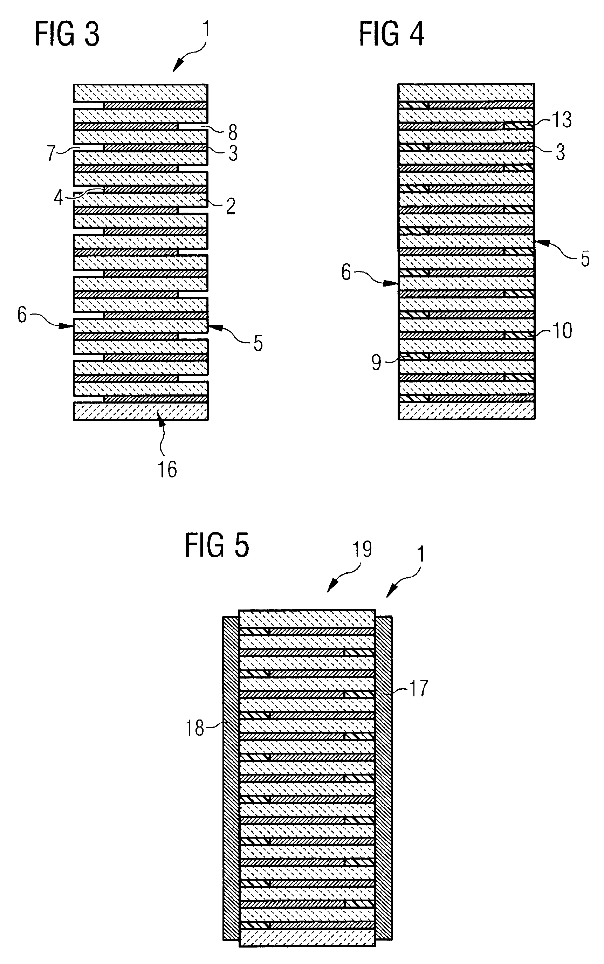

Die ersten und zweiten Kavitäten 7, 8 bilden erste und zweite Isolationszonen 9, 10, die die Elektrodenschichten 3, 4 elektrisch jeweils von einer Seitenfläche 5, 6 isolieren. Auf diese Weise können die ersten Elektrodenschichten 3 durch eine auf die erste Seitenfläche 5 aufgebrachte Außenelektrode 17 gemeinsam kontaktiert werden, während die zweiten Elektrodenschichten 4 von dieser Außenelektrode isoliert 17 sind. Dementsprechend können die zweiten Elektrodenschichten 4 durch eine auf die zweite Seitenfläche 6 aufgebrachte Außenelektrode 18 (siehe Figur 5) elektrisch kontaktiert werden. Die erste Außenelektrode 17 ist gestrichelt eingezeichnet, um eine mögliche Positionierung und Ausgestaltung der Außenelektrode 17 darzustellen. Die Außenelektroden 17, 18 können vor oder nach dem Befüllen der Kavitäten 7, 8 mit Isolationsmaterial aufgebracht werden.

Zusätzlich können durch die Kavitäten 7, 8 Sollbruchbereiche gebildet werden, in denen Risse im Körper 1 gezielt entstehen und geführt werden. Dadurch kann verhindert werden, dass sich ein Riss unkontrolliert im Körper 1 ausbreitet und bei einer Überbrückung von Elektrodenschichten 3, 4 zu einem Kurzschluss führt. Weiterhin können die Kavitäten 7, 8 auch zu einer mechanischen Entlastung in den Isolationszonen 9, 10 führen, so dass weniger Risse im Körper 1 entstehen.

In einer anderen Ausführungsform können die Kavitäten 7, 8 derart positioniert sein, dass sie nicht an Elektrodenschichten 3, 4 angrenzen. In diesem Fall können die Kavitäten 7, 8 nur zur mechanischen Entlastung oder als Sollbruchbereiche dienen.

Beispielsweise sind die Kavitäten 7, 8 in den Körper 1 eingeätzt. Derartige Kavitäten 7, 8 weisen beispielsweise eine Schlitzbreite in Stapelrichtung von ca. 2 µm auf.

Beim Anlegen einer Spannung an die Elektrodenschichten 3, 4 über auf die Seitenflächen 5, 6 aufgebrachte Außenkontaktierungen 17, 18 kann es zu einem unerwünschten elektrischen Durchbruch zwischen einem freiliegenden Elektrodenende 11, 12 und einer Außenkontaktierung 18, 17 kommen, die nicht mit der zugehörigen Elektrodenschicht 3, 4 verbunden ist.

Durch das Einbringen von Isolationsmaterial in die Kavitäten 7, 8 soll die elektrische Durchbruchsspannung erhöht werden und somit ein Durchbruch verhindert werden. Beispielsweise wird das Isolationsmaterial zumindest auf die Elektrodenenden 11, 12 aufgebracht. Somit kann die Austrittsarbeit von Elektronen aus den Elektrodenenden 11, 12 erhöht werden. Alternativ oder zusätzlich kann das Isolationsmaterial auch an einer anderen Stelle zwischen der Außenkontaktierung 18, 17 und einem Elektrodenende 11, 12 angeordnet sein. Beispielsweise kann das Isolationsmaterial derart in die Kavitäten 7, 8 eingebracht sein, dass es die Innenseite einer Außenkontaktierung 18, 17 bedeckt. Auch auf diese Weise kann ein Lawinendurchbruch verhindert werden.

Figur 2 zeigt in schematischer Darstellung ein Verfahren zum Einbringen von Isolationsmaterial in die Kavitäten des Körpers 1 aus Figur 1.

Dabei wird ein flüssiges Isolationsmaterial 13 in einem Behälter 14 bereitgestellt. Das Isolationsmaterial 13 weist vorzugsweise eine gute Benetzung auf dem dielektrischen Material auf. Insbesondere ist der Benetzungswinkel flach ausgebildet. In diesem Fall können die Kavitäten durch Kapillarkräfte gut aufgefüllt werden. Das Isolationsmaterial 13 kann zusätzlich auch zur Außenpassivierung des Körpers 1 verwendet werden.

In einer Ausführungsform weist das Isolationsmaterial 13 einen Lack auf. Insbesondere kann es sich um ein organisches Isolationsmaterial 13 handeln. Es eignet sich beispielsweise ein Silikonlack mit Xylol und Etylbenzen als Verdünner.

In einer weiteren Ausführungsform weist das Isolationsmaterial 13 Glas auf. Das Glas liegt beim Einbringen in die Kavitäten 7, 8 oberhalb der Schmelztemperatur vor. Beispielsweise weist das Glas eine Blei- oder Siliziumbasis auf.

Der Körper 1 wird teilweise in das Isolationsmaterial 13 eingebracht. Insbesondere wird er mit einer dritten Seitenfläche 15 in das Isolationsmaterial 13 eingebracht. Die Kavitäten 7, 8 liegen auf der dritten Seitenfläche 15 frei. Somit kann das Isolationsmaterial 13 gleichzeitig in die ersten und zweiten Kavitäten 7, 8 eindringen. Durch Kapillarkräfte steigt das Isolationsmaterial 13 in den Kavitäten 7, 8 nach oben. Dabei kann Luft aus den Kavitäten 7, 8 nach oben entweichen. Vorzugsweise steigt das Isolationsmaterial 13 bis zu einer gegenüberliegenden vierten Seitenfläche 16 auf. Somit werden die Kavitäten 7, 8 auf ihrer gesamten Länge vom Isolationsmaterial 13 befüllt. Dabei kann das Isolationsmaterial 13 die Kavitäten 7, 8 vollständig ausfüllen. Alternativ können die Kavitäten 7, 8 auch nur teilweise mit Isolationsmaterial 13 befüllt werden. In diesem Fall sind beispielsweise wenigstens die Elektrodenenden 11, 12 auf ihrer gesamten Länge vom Isolationsmaterial 13 bedeckt. Durch eine derartige Versiegelung der Elektrodenenden 11, 12, insbesondere der Kathodenspitzen, kann die Durchbruchspannung erhöht werden. Alternativ oder zusätzlich kann das Isolationsmaterial 13 an einer anderen Stelle zwischen den Elektrodenenden 11, 12 und der Ort der Außenelektroden 17, 18 vorhanden sein.

Das Isolationsmaterial 13 kann die Kavitäten 7, 8 auch nur auf einem Teil der Länge der Elektrodenenden 11, 12 befüllen. In diesem Fall ist das Isolationsmaterial 13 vorzugsweise wenigstens in einem Bereich zwischen den Elektrodenenden 11, 12 und dem Ort der Außenelektroden 17, 18 vorhanden.

Das durchgeführte Verfahren ist einstufig, so dass der Körper 1 nur einmal in das Isolationsmaterial 13 eingebracht wird. In einer nicht zur Erfindung gehörenden Alternative kann der Körper 1 auch mehrmals in das Isolationsmaterial 13 eingebracht werden. Beispielsweise wird er nach dem Einbringen der dritten Seitenfläche 15 anschließend mit seiner vierten Seitenfläche 16 in das Isolationsmaterial 13 eingebracht. Dies kann von Vorteil sein, wenn das Isolationsmaterial 13 beim ersten Einbringen des Körpers 1 in das Isolationsmaterial 13 nicht ganz nach oben steigt.

Ein Ausfüllen der Kavitäten 7, 8 unter Nutzung des Kapillareffekts ist besonders bei Kavitäten geringer Breite vorteilhaft, da durch den Kapillareffekt das Isolationsmaterial 13 kontrolliert in die schmale Kavität eingebracht werden kann.

Vor dem Einbringen des Körpers 1 in das Isolationsmaterial 13 können Teile des Körpers 1, die nicht mit Isolationsmaterial 13 bedeckt werden sollen, abgedeckt oder abgeklemmt werden. Nach dem Einbringen des Isolationsmaterials 13 wird das Isolationsmaterial 13 ausgehärtet. Bei einem Isolationsmaterial 13 auf Glasbasis kann das Isolationsmaterial 13 eingebrannt werden.

Der Körper 1 kann beim Einbringen des Isolationsmaterials 13 bereits mit Außenkontaktierungen 17, 18 versehen sein oder frei von Außenkontaktierungen sein. Mögliche Varianten des Verfahrensablaufs werden in den Figuren 3 bis 8 gezeigt. Die Figuren 3 bis 5 zeigen seitliche Aufsichten auf den Körper aus Figur 1 gemäß einem ersten Verfahrensablauf. Dabei zeigt Figur 3 den Körper 1 vor dem Einbringen von Isolationsmaterial. Es sind keine Außenkontaktierungen auf den Seitenflächen 5, 6 aufgebracht, so dass die Kavitäten 7, 8 auf beiden Seitenflächen 5, 6 freiliegen. Der Körper 1 wird ohne Außenkontaktierungen beispielsweise in das flüssige Isolationsmaterial 13 wie in Figur 2 gezeigt eingebracht.

In einer nicht zur Erfindung gehörenden Alternative kann das Isolationsmaterial 13 auf die Seitenflächen 5, 6, beispielsweise durch Siebdruck, aufgebracht werden. Dieses Verfahren eignet sich besonders gut für Glas als Isolationsmaterial 13. Das Isolationsmaterial 13 kann als Paste auf die Seitenflächen 5, 6 aufgebracht und über einen Einbrandprozess verflüssigt werden. Durch die Kapillarkräfte wird das Isolationsmaterial 13 in die Kavitäten 7, 8 hineingezogen. Beispielsweise befüllt das Isolationsmaterial 13 nur den Bereich der Kavitäten 7, 8 nahe den Seitenflächen 5, 6 und dringt nicht bis zu den Elektrodenenden 11, 12 vor.

Figur 4 zeigt den Körper 1 aus Figur 3 nach dem Einbringen des Isolationsmaterials 13. Die Isolationszonen 9, 10 sind hier vollständig mit dem Isolationsmaterial 13 gefüllt. Das Isolationsmaterial 13 wird nach oder beim Einbringen in die Kavitäten 7,8 ausgehärtet oder eingebrannt. Anschließend können die Seitenflächen 5, 6, 15, 16 poliert werden, um überschüssiges Isolationsmaterial 13 zu entfernen. Beispielsweise wird durch eine Polierung der ersten Seitenfläche 5 Isolationsmaterial 13 von den ersten Elektrodenschichten 3 entfernt.

Danach werden auf die ersten und zweiten Seitenflächen 5, 6 Außenkontaktierungen aufgebracht.

Figur 5 zeigt den Körper 1 nach dem Aufbringen von Außenkontaktierungen 17, 18. Die Außenkontaktierungen 17, 18 sind beispielsweise als Metallpasten auf die Seitenflächen 5, 6 aufgebracht und anschließend eingebrannt. In einer alternativen Ausführungsform werden die Außenkontaktierungen 17, 18 in einem Sputterverfahren aufgebracht. In einer weiteren alternativen Ausführungsform können die Außenkontaktierungen 17, 18 als Leitkleber ausgebildet sein.

Beispielsweise liegt nun ein fertiges Bauelement 19 vor. In einer alternativen Ausführungsform wird der Körper 1 in mehrere Grundkörper für Bauelemente zertrennt. Dieser Schritt kann vor oder nach dem Aushärten des Lacks, vor oder nach dem Polieren der Seitenflächen 5, 6, 15, 16 oder vor oder nach dem Anbringen der Außenkontaktierungen 17, 18 erfolgen.

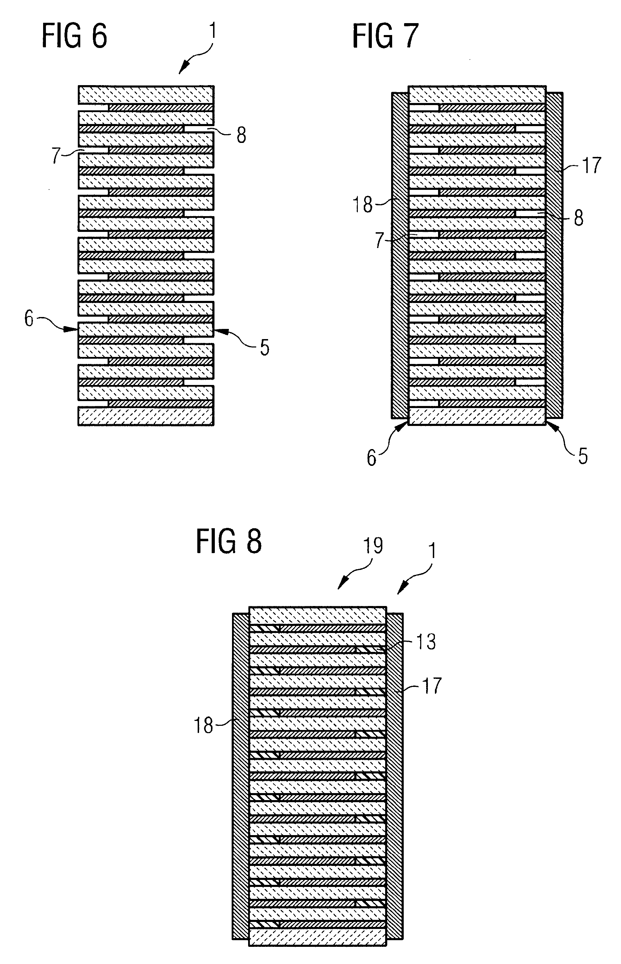

Die Figuren 6 bis 8 zeigen seitliche Aufsichten auf den Körper 1 aus Figur 1 gemäß einem zweiten Verfahrensablauf.

Gemäß diesem Verfahrensablauf werden Außenkontaktierungen 17, 18 auf den Körper 1 aufgebracht, bevor das Isolationsmaterial 13 eingebracht wird. Dies ermöglicht es insbesondere, ein organisches Isolationsmaterial 13 bei eingebrannten Außenkontaktierungen 17, 18 zu verwenden.

Figur 6 zeigt den Körper 1 vor dem Einbringen von Isolationsmaterial und vor dem Aufbringen von Außenkontaktierungen.

Figur 7 zeigt den Körper 1 nach dem Aufbringen von Außenkontaktierungen 17, 18 auf die gegenüberliegenden Seitenflächen 5, 6. Beispielsweise werden die Außenkontaktierungen 17, 18 durch Metallisierungspasten hergestellt, die auf die Seitenflächen 17, 18 aufgetragen und eingebrannt werden.

Die Kavitäten 7, 8 sind noch frei von Isolationsmaterial, so dass sich unter den Außenkontaktierungen 17, 18 Hohlräume befinden.

Anschließend wird in die Kavitäten 7, 8, wie in Figur 2 dargestellt, Isolationsmaterial 13 eingebracht. Da hier die Außenkontaktierungen 17, 18 schon mit den Elektrodenschichten 3, 4 verbunden sind, kann der Schritt des Polierens der Oberfläche nach dem Einbringen des Isolationsmaterials 13 entfallen.

Figur 8 zeigt den Körper 1 nach dem Einbringen des Isolationsmaterials 13. Das Isolationsmaterial 13 ist ausgehärtet. Beispielsweise liegt nun ein fertiges Bauelement 19 vor. Alternativ kann der Körper 1 in mehrere Grundkörper für Bauelemente zertrennt werden. Dieses Schritt kann alternativ vor oder nach dem Aufbringen der Außenkontaktierung 17, 18 oder vor oder nach dem Einbringen des Isolationsmaterials 13 erfolgen. Das Bauelement 19 kann insbesondere ein organisches Isolationsmaterial 13 und eingebrannte Außenkontaktierungen 17, 18 aufweisen.

### Bezugszeichenliste

- 1: Körper
- 2: dielektrische Schicht
- 3: erste Elektrodenschicht
- 4: zweite Elektrodenschicht
- 5: erste Seitenfläche
- 6: zweite Seitenfläche
- 7: erste Kavität
- 8: zweite Kavität
- 9: erste Isolationszone
- 10: zweite Isolationszone
- 11: erstes Elektrodenende
- 12: zweites Elektrodenende
- 13: Isolationsmaterial
- 14: Behälter
- 15: dritte Seitenfläche
- 16: vierte Seitenfläche
- 17: erste Außenkontaktierung
- 18: zweite Außenkontaktierung
- 19: Bauelement

- S: Stapelrichtung

## Patentansprüche

1. Verfahren zur Herstellung eines elektrischen Bauelements mit den Schritten:
A) Bereitstellen eines Körpers (1) aufweisend wenigstens eine Kavität (7, 8),
B) zumindest teilweises Befüllen der Kavität (7, 8) mit einem Isolationsmaterial (13) durch Kapillarkräfte, wobei der Körper (1) mit nur einer Seitenfläche (15) in das Isolationsmaterial (13) eingebracht wird und das Isolationsmaterial (13) aufgrund von Kapillarkräften in die Kavität (7, 8) wandert.

2. Verfahren nach Anspruch 1,
wobei die Kavität (7, 8) in den Körper (1) eingeätzt ist.

3. Verfahren nach einem der Ansprüche 1 oder 2,
wobei vor Schritt B) eine Außenkontaktierung (17, 18) auf den Körper (1) aufgebracht wird.

4. Verfahren nach Anspruch 3,
wobei die Außenkontaktierung (17, 18) die Kavität (7, 8) zumindest teilweise bedeckt.

5. Verfahren nach einem der Ansprüche 1 bis 4,
wobei nach Schritt B) eine Außenkontaktierung (17, 18) auf den Körper (1) aufgebracht wird.

6. Verfahren nach einem der Ansprüche 3 bis 5,
wobei die Außenkontaktierung (17, 18) eingebrannt wird.

7. Verfahren nach einem der Ansprüche 1 bis 6,
wobei das Isolationsmaterial (13) Lack oder Glas aufweist.

8. Verfahren nach einem der Ansprüche 1 bis 7,
wobei der Körper (1) wenigstens eine Elektrodenschicht (3, 4) aufweist und wobei die Kavität (7, 8) an die Elektrodenschicht (3, 4) unmittelbar angrenzt.

9. Verfahren nach einem der Ansprüche 1 bis 8,
wobei der Körper (1) wenigstens eine Elektrodenschicht (3, 4) aufweist und wobei nach Schritt B) das Isolationsmaterial (13) zumindest ein Ende (11, 12) der Elektrodenschicht (3, 4) bedeckt.

10. Verfahren nach einem der Ansprüche 1 bis 7,
wobei die Kavität (7, 8) nicht an eine Elektrodenschicht (3, 4) unmittelbar angrenzt.

11. Verfahren nach einem der Ansprüche 1 bis 10,
wobei Teile des Körpers (1) vor Schritt B) abgedeckt werden.

12. Verfahren nach einem der Ansprüche 1 bis 11,
wobei der Körper (1) nach Schritt B) in mehrere Grundkörper für elektrische Bauelemente (19) zertrennt wird.

13. Verfahren nach einem der Ansprüche 1 bis 12,
wobei der Körper (1) Kavitäten (7, 8) auf verschiedenen Seitenflächen (5, 6) aufweist und wobei das Isolationsmaterial (13) gleichzeitig in die Kavitäten (7, 8) auf den verschiedenen Seitenflächen (5, 6) eingebracht wird, so dass der Körper (1) nur einmal in das Isolationsmaterial (13) eingebracht wird.

14. Verfahren nach einem der Ansprüche 1 bis 13,
wobei der Körper (1) in Schritt B) zumindest teilweise in das flüssige Isolationsmaterial (13) eingebracht wird.

## Claims

1. Method for producing an electric component comprising the following steps:
A) providing a body (1) having at least one cavity (7, 8),
B) at least partly filling the cavity (7, 8) with an insulation material (13) by means of capillary forces, wherein the body (1) is introduced into the insulation material (13) by only one side surface (15) and the insulation material (13) migrates into the cavity (7, 8) on account of capillary forces.

2. Method according to Claim 1,
wherein the cavity (7, 8) is etched into the body (1).

3. Method according to either of Claims 1 and 2, wherein before step B) external contact-connection (17, 18) is applied to the body (1).

4. Method according to Claim 3,
wherein the external contact-connection (17, 18) at least partly covers the cavity (7, 8).

5. Method according to any of Claims 1 to 4,
wherein after step B) external contact-connection (17, 18) is applied to the body (1).

6. Method according to any of Claims 3 to 5, wherein the external contact-connection (17, 18) is fired.

7. Method according to any of Claims 1 to 6, wherein the insulation material (13) comprises lacquer or glass.

8. Method according to any of Claims 1 to 7,
wherein the body (1) has at least one electrode layer (3, 4) and wherein the cavity (7, 8) directly adjoins the electrode layer (3, 4).

9. Method according to any of Claims 1 to 8,
wherein the body (1) has at least one electrode layer (3, 4) and wherein after step B) the insulation material (13) covers at least one end (11, 12) of the electrode layer (3, 4).

10. Method according to any of Claims 1 to 7,
wherein the cavity (7, 8) does not directly adjoin an electrode layer (3, 4).

11. Method according to any of Claims 1 to 10,
wherein parts of the body (1) are covered before step B).

12. Method according to any of Claims 1 to 11,
wherein the body (1) is separated into a plurality of main bodies for electric components (19) after step B).

13. Method according to any of Claims 1 to 12,
wherein the body (1) has cavities (7, 8) on different side surfaces (5, 6) and wherein the insulation material (13) is introduced into the cavities (7, 8) on the different side surfaces (5, 6) simultaneously, such that the body (1) is introduced into the insulation material (13) only once.

14. Method according to any of Claims 1 to 13,
wherein the body (1) is introduced at least partly into the liquid insulation material (13) in step B).

## Revendications

1. Procédé de fabrication d'un élément électrique, comprenant les étapes suivantes:
A) préparer un corps (1) présentant au moins une cavité (7, 8),
B) remplir au moins partiellement la cavité (7, 8) avec un matériau isolant (13) par des forces de capillarité, dans lequel le corps (1) n'est introduit dans le matériau isolant (13) qu'avec une face latérale (15) et le matériau isolant (13) migre dans la cavité (7, 8) sous l'action des forces de capillarité.

2. Procédé selon la revendication 1, dans lequel la cavité (7, 8) est gravée dans le corps (1).

3. Procédé selon une des revendications 1 ou 2, dans lequel on installe avant l'étape B) un contact extérieur (17, 18) sur le corps (1).

4. Procédé selon la revendication 3, dans lequel le contact extérieur (17, 18) recouvre au moins en partie la cavité (7, 8).

5. Procédé selon l'une quelconque des revendications 1 à 4, dans lequel on installe après l'étape B) un contact extérieur (17, 18) sur le corps (1).

6. Procédé selon l'une quelconque des revendications 3 à 5, dans lequel on recuit le contact extérieur (17, 18) .

7. Procédé selon l'une quelconque des revendications 1 à 6, dans lequel le matériau isolant (13) présente de la laque ou du verre.

8. Procédé selon l'une quelconque des revendications 1 à 7, dans lequel le corps (1) présente au moins une couche d'électrode (3, 4) et dans lequel la cavité (7, 8) est directement adjacente à la couche d'électrode (3, 4) .

9. Procédé selon l'une quelconque des revendications 1 à 8, dans lequel le corps (1) présente au moins une couche d'électrode (3, 4) et dans lequel, après l'étape B), le matériau isolant (13) recouvre au moins une extrémité (11, 12) de la couche d'électrode (3, 4).

10. Procédé selon l'une quelconque des revendications 1 à 7, dans lequel la cavité (7, 8) n'est pas directement adjacente à une couche d'électrode (3, 4).

11. Procédé selon l'une quelconque des revendications 1 à 10, dans lequel des parties du corps (1) sont recouvertes avant l'étape B).

12. Procédé selon l'une quelconque des revendications 1 à 11, dans lequel le corps (1) est divisé après l'étape B) en plusieurs corps de base pour des éléments électriques (19).

13. Procédé selon l'une quelconque des revendications 1 à 12, dans lequel le corps (1) présente des cavités (7, 8) sur différentes faces latérales (5, 6) et dans lequel le matériau isolant (13) est introduit en même temps dans les cavités (7, 8) sur les différentes faces latérales (5, 6), de telle manière que le corps (1) ne soit introduit qu'une seule fois dans le matériau isolant (13).

14. Procédé selon l'une quelconque des revendications 1 à 13, dans lequel le corps (1) est introduit au moins en partie dans le matériau isolant liquide (13) à l'étape B).
